# EUROPEAN PATENT APPLICATION

(11) **EP 1 728 723 A1**
(43) Date of publication of application: **06.12.2006**
(21) Application number: 05721308.4
(22) Date of filing: 23.03.2005
(51) Int. Cl.: B65D 1/00, B32B 9/00, B32B 7/00

(54) **SYNTHETIC RESIN CONTAINER WITH HIGH GAS BARRIER PERFORMANCE**

(30) Priority: 26.03.2004 JP 2004093586; 31.01.2005 JP 2005023684
(71) Applicant: Yoshino Kogyosho Co., Ltd., Tokyo 136-8531 (JP)
(72) Inventor: TAKADA, Makoto, YOSHINO KOGYOSHO CO., LTD., Matsudo-shi, Chiba 2702297 (JP); TATENO, Hironori, YOSHINO KOGYOSHO CO., LTD., Matsudo-shi, Chiba 2702297 (JP); INABA, Junichi, YOSHINO KOGYOSHO CO., LTD., Tokyo 1368531 (JP); HAYASE, Takayuki, YOSHINO KOGYOSHO CO., LTD., Tokyo 1368531 (JP); SUZUKI, Masato, YOSHINO KOGYOSHO CO., LTD., Isehara-shi, Kanagawa 2591103 (JP); SUGAI, Masahiro, YOSHINO KOGYOSHO CO., LTD., Isehara-shi, Kanagawa 2591103 (JP); IMAI, Toshio, YOSHINO KOGYOSHO CO., LTD., Matsudo-shi, Chiba 2702297 (JP); HATTORI, Masao, YOSHINO KOGYOSHO CO., LTD., Tokyo 1368531 (JP)
(74) Representative: Gray, James
(86) International application number: PCT/JP2005/005258
(87) International publication number: WO 2005/092715

(57) **Abstract**

A synthetic resin container possessing a higher gas barrier property, and having a coating film possessing a higher gas barrier property and positioned on an inner surface and/or outer surface of a body of the container, wherein the coating film (2) is constituted of a layered coating including at least a gas barrier coating (2a) and a cover coating (2b), the cover coating being positioned at a topmost side of the coating film. The cover coating (2b) includes a layer positioned at a topmost side of the cover coating and possessing such a water repellency that the layer has a contact angle with water of 80° to 100°. The layers (2a, 2b) constituting the coatings, respectively, are each formed by vapor deposition and each have a refractive index in a range of 1.3 to 1.6.

## Description

### TECHNICAL FIELD

The present invention relates to a synthetic resin container represented by a bottle made of polyethylene terephthalate, i.e., represented by a so-called PET bottle, and contemplates preventing permeation of gas, particularly oxygen gas, through the container to thereby stabilize and preserve a quality of the contents of the container.

### BACKGROUND ART

There have been recently and frequently used blow molded containers made of synthetic resin such as those for containing therein soft drinks, alcoholic beverages, edible oils, soy sauces, and the like, from a standpoint that such containers are easy to handle and are excellent in disposition, transference, recycle, and the like. It is inevitable for this kind of container that oxygen gas and/or carbon dioxide gas permeates through the container as compared with a glass-made container, thereby causing anxiety about a shortened period of time, i.e., so-called shelf-life, over which the quality of contents of the container can be kept.

As a technique for dealing with such a problem, for example, JP-A-2000-109076 has proposed a bottle including an inner surface having thereon a coating film (SiOₓ) possessing a higher gas barrier property and coated thereto by vapor deposition or sputtering.

Although the container according to the above related art is capable of providing an improved oxygen barrier property which is several times as high as that of a container without coating, it is inevitable for the gas barrier property inherently possessed by the container to be lowered particularly when the container is to be filled with contents at temperatures exceeding 80°C (this is suppose to be due to occurrence of cracks within a barrier coating) thereby requiring an improvement in this point.

In turn, in containers each including an outer surface provided with a coating film thereon possessing a higher gas barrier property, it is worried that the gas barrier property is lowered particularly when each container is subjected to a sterilizing treatment or the like for the contents such that the outer surface of the container is showered with hot water.

### DISCLOSURE OF THE INVENTION

It is therefore an object of the present invention to propose a novel container made of synthetic resin capable of unchangedly preserving a higher gas barrier property even if the container is exposed to high temperatures at the interior and/or exterior thereof such as when the container is to be filled with hot contents and/or when the container is subjected to a heat treatment by hot water shower or the like.

The present invention resides in a synthetic resin container possessing a higher gas barrier property, and having a coating film possessing a higher gas barrier property and positioned on an inner surface and/or outer surface of a body of the container, characterized in that the coating film comprises a layered coating including at least a gas barrier coating and a cover coating, the cover coating being positioned at a topmost side of the coating film, that the cover coating includes a layer positioned at a topmost side of the cover coating and possessing such a water repellency that the layer has a contact angle with water of 80° to 100°, and that the layers constituting the coatings, respectively, are each formed by vapor deposition and each have a refractive index in a range of 1.3 to 1.6.

Herein, the phrase that "the cover coating being positioned at a topmost side of the coating film" means that the cover coating is positioned more outside or farther from an applicable surface than the gas barrier coating arranged on the applicable surface such that the cover coating covers the gas barrier coating, no matter whether the coating film is provided on an inner surface or outer surface of the container body.

According to the present invention, provided on an inner surface and/or outer surface of a container body, are a gas barrier coating and a cover coating cooperatively acting as a layered coating where the cover coating is arranged at a topmost side of the layered coating, so that the gas barrier property of the container is never affected even when the container is filled with hot contents or is subjected to a treatment by hot water shower. Particularly, the gas barrier property can be more enhanced by providing both the inner surface and outer surface of the container with layered coatings, respectively.

In the container having the above configuration, it is desirable that the gas barrier coating and the cover coating are arranged adjoinedly to each other. Further, it is preferable that the gas barrier coating is a silicon oxide compound layer including silicon oxide as a main component, and the cover coating is an organic silicon compound layer.

It is possible to provide a base coating comprising an organic silicon compound layer, between the layered coating and a topmost surface of the container body.

### BRIEF DESCRIPTION OF THE DRAWINGS

The present invention will be described more concretely with reference to the drawings.

FIG. 1 is a cross-sectional view of an essential part of a container according to an embodiment of the present invention.

FIG. 2 is a cross-sectional view of an essential part of a container according to another embodiment of the present invention.

FIG. 3 is a graph of a comparison between oxygen permeation amounts and BIF values.

### BEST MODE FOR CARRYING OUT THE INVENTION

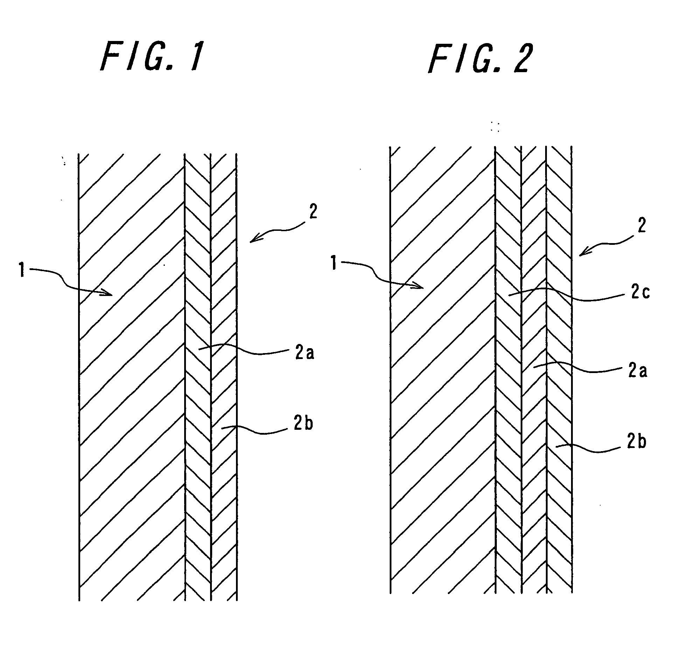

FIG. 1 shows an essential part of a container made of a polyethylene terephthalate resin molded by biaxial-stretching blow molding, in which reference numeral 1 designates a wall portion constituting a container body, and 2 designates a coating film provided on an inner surface of the wall portion 1 and having a higher barrier property for preventing permeation of gas (particularly, oxygen gas, carbon dioxide gas, and the like) through the container from the interior to the exterior or vice versa.

In FIG. 1, the coating film 2 comprises: a silicon oxide compound layer 2a (which is a layer having a barrier property for mainly preventing permeation of gas), including a silicon oxide compound (SiOₓ) as a main component, and adjoined to the wall portion 1; and an organic silicon compound layer 2b positioned on a surface of the silicon oxide compound layer 2a.

The gas barrier property can be unchangedly preserved even when the container is filled with hot contents, by providing the organic silicon compound layer 2b on the silicon oxide compound layer 2a possessing the higher gas barrier property, at a side of the latter opposite to the wall portion.

Of the layers constituting the coating film 2, the silicon oxide compound layer 2a is made of a silicon oxide (SiOₓ) compound and a compound (i.e., layer mainly including silicon oxide) including at least silicon, carbon, hydrogen, and oxygen, while the organic silicon compound layer 2b is made of a compound including at least silicon, carbon, hydrogen, and oxygen.

The silicon oxide compound layer 2a exhibits a contact angle with water in a range of 20° to 40°, while the organic silicon compound layer 2b is a membrane possessing a higher water repellency by exhibiting a contact angle with water in a range of 80° to 100°. It is expected that the lowering of the gas barrier property can be restricted even when the cracks have been caused within the hydrophilic layer or the like arranged as the intermediate layer by setting the contact angle with water in the range of 80° to 100° for the layer positioned at the topmost side of the coating film 2, because there can be then avoided infiltration of water into the cracks, or escalation of the cracks due to infiltrated water.

The layers constituting the coatings, respectively, are each configured to have a refractive index of 1.3 to 1.6. Setting the refractive indexes of the layers in a range of 1.3 to 1.6 enables preservation of an excellent transparency of the container.

FIG. 2 shows another embodiment of the present invention, including another organic silicon compound layer 2c as a base coating arranged between a wall portion 1 of a container body and a silicon oxide compound layer 2a. The organic silicon compound layer 2c is made of a compound including at least silicon, carbon, hydrogen, and oxygen. It has been confirmed that the interposition of such an organic silicon compound layer 2c enables exhibition of a gas barrier property higher than that of the two-layered coating film without the organic silicon compound layer 2c. As the reason thereof, it is supposed that the organic silicon compound layer 2c interposed between the silicon oxide compound layer 2a and the polyethylene terephthalate of the container body enhances the adherence between them so that cracks or the like are hardly caused in the silicon oxide compound layer 2a even upon exertion of impact or the like thereon at the time of deposition of the organic silicon compound layer 2b.

No particular limitations are applied to the silicon oxide compound layer 2a, and organic silicon compound layers 2b, 2c, because various coatings can be formed by appropriately adjusting types of gases, gas flows, and radio frequency (RF) outputs in a deposition process.

Similarly, no particular limitations are applied to the gas barrier coating, cover coating, and base coating, because they can be each made of a coating formed of a single layer as described above, or each made of a layered coating formed of a plurality of laminated layers.

In a situation where the coating film is made of a layered coating of three layers including the base coating, gas barrier coating, and cover coating in an order from the wall portion 1 and no matter whether the coating film is arranged inside or outside the container, it is possible to utilize as the base coating an organic silicon compound layer useful for adherence of the gas barrier coating to the wall portion, and in this case, it is enough to prepare two kinds of conditions as the deposition conditions by setting composition ratios for the base coating to be substantially the same as those for the cover coating, thereby avoiding increase of the number of gas species to be used in the vapor deposition treatment.

### Embodiments

There were formed coating films on inner surfaces of heat-proofed PET bottles by plasma CVD utilizing radio frequency pulses, respectively, and there was conducted an evaluation of oxygen barrier property (oxygen permeability and water-vapor permeability). Note that the pulse discharge condition in the plasma CVD was: On: 0.1 sec, and Off: 0.1 sec.

Table 1 shows a result from the bottle having the layered coating comprising the PET (inner wall)/organic silicon compound layer/silicon oxide compound layer/organic silicon compound layer. Table 2 shows a result from a bottle provided with a silicon oxide compound layer only. Table 3 shows a result from a bottle having a layered coating comprising a PET (inner wall)/organic silicon compound layer/silicon oxide compound layer. Further, Table 4 shows a result from a bottle having a layered coating comprising a PET/silicon oxide compound layer/organic silicon compound layer.

Note that, in the tables, "DEPO" represents a discharge time (for example, 8 means pulse discharge for 8 seconds); "HMDSO" represents hexamethyl-disiloxane; and "sccm" for gas flow represents a gas amount (cc) to be flowed during one minute under a condition of 0°C and at 1 atmosphere. Further, the "composition ratios of starting gases" represent ratios in a mixed state of gases including HMDSO, oxygen, nitrogen, argon, and the like; the "water-vapor permeability at 40°C-75% RH" represents the temperature and the relative humidity in the storage environment; and "BIF" represents a barrier improvement factor compared with a bottle without deposition of a coating film.

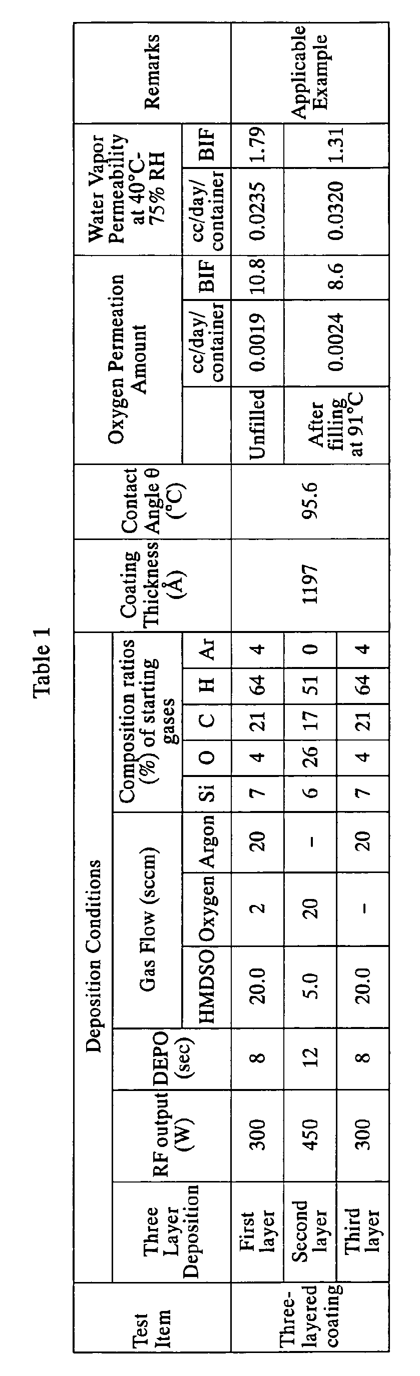

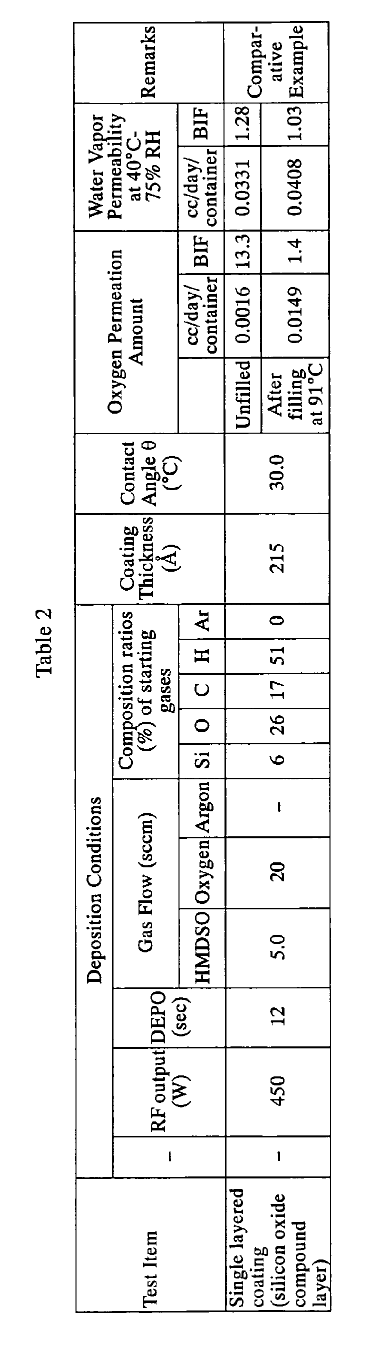

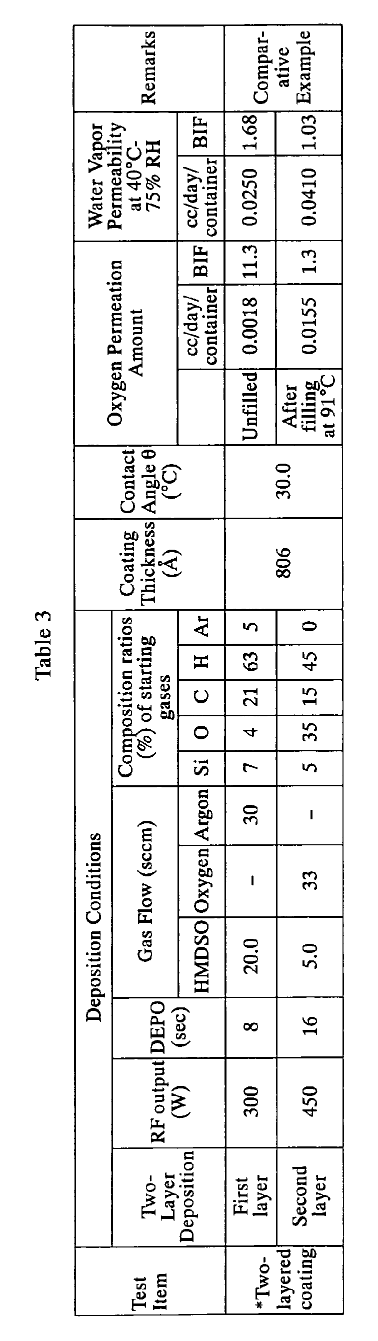

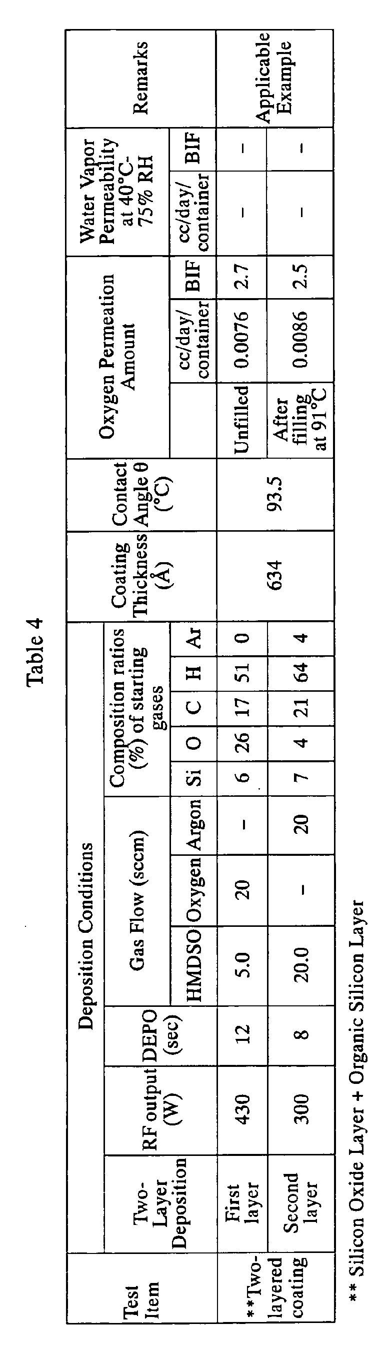

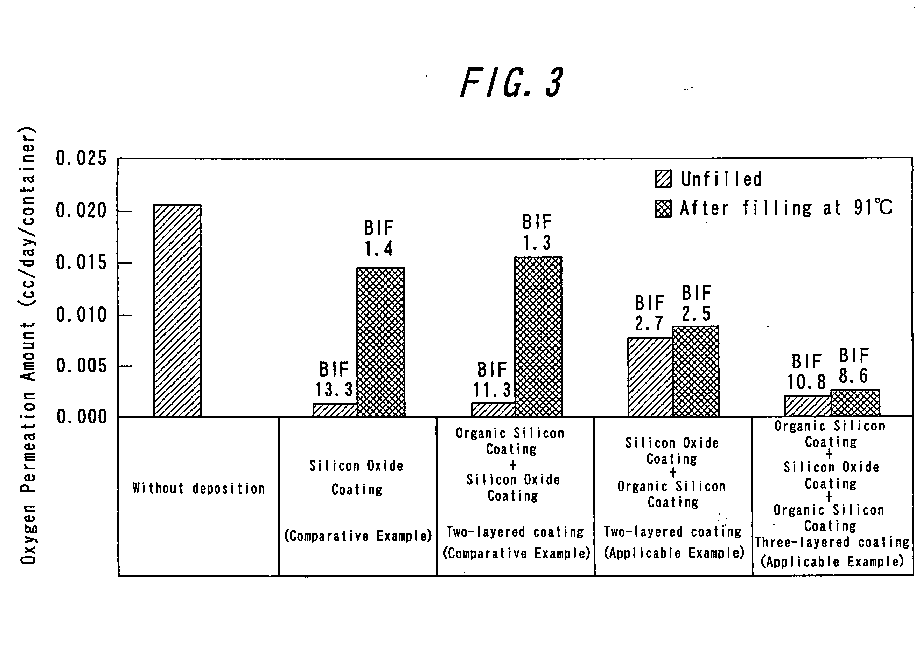

FIG. 3 is a graph showing oxygen permeation amounts and BIF values of Table 1 to Table 4 in a compared manner. As apparent from FIG. 3, it can be confirmed that higher barrier properties can be preserved in the containers (applicable examples) according to the present invention without substantial affection by heat even when filled with contents at 91°C.

As apparent from the above, the present invention can provide a synthetic resin container capable of preserving a higher gas barrier property even when the interior and/or exterior of the container is exposed to high temperatures by hot filling, hot water shower or the like.

## Claims

1. A synthetic resin container possessing a higher gas barrier property, and having a coating film possessing a higher gas barrier property and positioned on an inner surface and/or outer surface of a body of the container, **characterized in**
**that** said coating film comprises a layered coating including at least a gas barrier coating and a cover coating, said cover coating being positioned at a topmost side of said coating film,
**that** said cover coating includes a layer positioned at a topmost side of said cover coating and possessing such a water repellency that said layer has a contact angle with water of 80° to 100°, and
**that** the layers constituting said coatings, respectively, are each formed by vapor deposition and each have a refractive index in a range of 1.3 to 1.6.

2. The synthetic resin container of claim 1, wherein said gas barrier coating and said cover coating are arranged adjoinedly to each other.

3. The synthetic resin container of claim 1 or 2, further comprising a base coating between said layered coating and a topmost surface of said container body.

4. The synthetic resin container of claim 1 or 2, wherein said gas barrier coating is a silicon oxide compound layer including silicon oxide as a main component, and said cover coating is an organic silicon compound layer.

5. The synthetic resin container of claim 4, further comprising a base coating between said layered coating and a topmost surface of said container body, and wherein said base coating comprises an organic silicon compound layer.
